# EUROPEAN PATENT APPLICATION

(11) **EP 1 391 986 A1**
(43) Date of publication of application: **25.02.2004**
(21) Application number: 02018703.5
(22) Date of filing: 21.08.2002
(51) Int. Cl.: H03F 3/60, H01P 1/213

(54) **Multi-band amplifier**

(71) Applicant: TDK Corporation, Chuo-ku, Tokyo (JP)
(72) Inventor: Humphrey, Denver, Edward, Johnston, Ardvanagh, County Antrim, Northern Ireland BT43 7HD (GB)
(74) Representative: Wallace, Alan

(57) **Abstract**

The preferred embodiment of the invention provides a dual-band amplifying apparatus, particularly for use in a cellular telephone, in which first and second amplifying sections are electrically connected to each other at a common input and a common output. When the respective amplifier of one amplifying section is disabled, the disabled amplifying section is arranged to present an impedance at the common input and common output which is substantially open-circuit to signals in the frequency band of the other amplifying section. This arrangement eliminates the need to provide switching circuitry to isolate the amplifying sections.

## Description

### FIELD OF THE INVENTION

The present invention relates to amplifiers and in particular to multi-band amplifiers for mobile telecommunications apparatus.

### BACKGROUND TO THE INVENTION

Mobile telecommunications apparatus, such as mobile (or cellular) telephones, are increasingly designed to operate with mobile communications networks which have two or more operating frequencies, or in areas where two or more mobile communication networks are available, each operating in its own frequency band. Currently, the common operating frequency bands for mobile telecommunications networks in Europe are GSM (Global System for Mobile Telecommunications) which operates at about 900 MHz and DCS (Digital Communications System) which operates at about 1800 MHz. Other countries have their own systems - for example the AMPS (Advanced Mobile Phone System) operates at approximately 800 MHz in the United States of America along with the PCS (Personal Communications System) band which operates at about 1900 MHz. Increasingly, manufacturers have sought to increase the versatility of their products by providing mobile telephones which can operate in two or more different frequency bands. These are sometimes known as dual-band, or multi-band telephones.

Dual-band, or multi-band telephones typically comprise dual-band, or multi-band transmitters which, in turn, typically comprise dual-band, or multi-band amplifiers.

The present invention concerns improvements in and relating to multi-band amplifiers. In particular, a perceived problem with conventional multi-band amplifiers is the requirement for switches and diplexers and/or additional RF input and output ports to isolate the respective amplifying sections and to control the passage of signals through the amplifier. The presence of the switches, and the need to provide control signals for the switches, and diplexers can add significantly to the complexity of the multi-band amplifier.

While the present invention is particularly concerned with dual-band amplifiers, it will be noted that at least some aspects of the invention are suitable for use in apparatus capable of operating in three or more different frequency bands.

### SUMMARY OF THE INVENTION

A first aspect of the invention provides an amplifying apparatus for amplifying a signal having a frequency in one of a plurality of frequency bands, the apparatus comprising: a first amplifying section comprising an amplifier arranged to operate in a first of said frequency bands; a second amplifying section comprising an amplifier arranged to operate in a second of said frequency bands; and at least one common connection point to which each of the first and second amplifying sections is electrically connected, wherein, when the respective amplifier of said first or second amplifying section is disabled, the respective first or second amplifying section is arranged to present an impedance at said at least one common connection point which is substantially open-circuit to signals in said second or first frequency bands respectively.

This arrangement simplifies the amplifying apparatus by eliminating the need for switching circuitry to isolate the amplifying sections, the need to provide corresponding switch control signals, the need for a diplexer or the need for additional RF input or output ports.

Preferably, said at least one common connection point comprises a common output, the respective outputs of the first and second amplifying sections being electrically connected to each other at the common output. More preferably, each amplifying section comprises a respective output transmission line between the common output and the respective amplifier, the length of the output transmission line being arranged to adjust the impedance presented at said common output by the respective amplifying section when disabled.

Preferably, the apparatus comprises a common connection point in the form of a common input by which said signal may be supplied to one or other of said amplifying sections, wherein said first and second amplifying sections are electrically connected to each other at said common input and wherein, when the respective amplifier of said first or second amplifying section is disabled, the respective first or second amplifying section is arranged to present an impedance at said common input which is substantially open-circuit to signals in said second or first frequency bands respectively. More preferably, each amplifying section comprises a respective input transmission line between the common input and the respective amplifier, the length of the input transmission line being arranged to adjust the impedance presented at said common input by the respective amplifying section when disabled.

Preferably, the respective output transmission line and/or the respective input transmission line is arranged to add to the reactive component of the respective amplifying section when disabled.

In the preferred embodiment, the respective amplifier of the first and second amplifying section is associated with a respective enable switch operable by a respective enable signal for enabling the respective amplifier when the signal is in the first and second frequency bands respectively and to disable the respective amplifier when the signal is in said second and first bands respectively.

A second aspect of the invention provides a dual-band transmitter comprising an apparatus according to the first aspect of the invention.

A third aspect of the invention provides a mobile telecommunications apparatus comprising a dual-band transmitter according to the second aspect of the invention.

A fourth aspect of the invention provides a computer program product comprising computer useable instructions for generating an apparatus according to the first aspect of the invention.

A fifth aspect of the invention provides a method of isolating first and second amplifying sections in an amplifying apparatus, the method comprising: arranging the respective first or second amplifying section to present, when the respective amplifier of said first or second amplifying section is disabled, an impedance at said common output which is substantially open-circuit to signals in said second or first frequency bands respectively.

A sixth aspect of the invention provides an amplifying apparatus for amplifying a signal having a frequency in one of a plurality of frequency bands, the apparatus comprising: a first amplifying section comprising an amplifier arranged to operate in a first of said frequency bands; a second amplifying section comprising an amplifier arranged to operate in a second of said frequency bands; wherein the respective amplifier of the first and second amplifying section is associated with a respective enable switch operable by a respective enable signal to enable the respective amplifier when the signal is in the first and second frequency bands respectively and to disable the respective amplifier when the signal is in said second and first bands respectively, the amplifier of each amplifying stage comprising a variable gain amplifier and the apparatus further comprising a gain controller arranged to generate a gain control signal for adjusting the gain of the amplifiers, wherein the gain control signal is supplied to each of the gain control inputs of the power amplifiers via the respective enable switches.

Preferred features of the invention are recited in the dependent claims. Other advantageous aspects of the invention will become apparent to those ordinarily skilled in the art upon review of the following description of specific embodiments of the invention and with reference to the accompanying drawings.

### BRIEF DESCRIPTION OF THE DRAWINGS

Embodiments of the invention are now described by way of example and with reference to the accompanying drawings in which:
Figure 1 is a schematic view of the transmit path as may be found in a cellular telephone;
Figure 2 is a block diagram of one type conventional dual-band transmitter included in the transmit path of Figure 1;
Figure 3 is a block diagram of a dual-band amplifying apparatus according to a preferred embodiment of one aspect of the present invention;
Figure 4 is a block diagram of an alternative embodiment of the amplifying apparatus of Figure 3;
Figure 5 is a block diagram of a power amplifier included in the amplifying apparatus of Figures 3 and 4;
Figure 6 is a schematic view of a switch associated with the power amplifier of Figure 5;
Figure 7a shows a Smith Chart illustrating the output impedance of a disabled amplifier in a non-operational frequency band;
Figure 7b shows a Smith Chart illustrating the output impedance of Figure 7a combined with a length of transmission line in accordance with one aspect of the present invention;
Figure 7c shows a Smith Chart illustrating the input impedance of the disabled amplifier of Figure 7a; and
Figure 8 is a block diagram of an alternative embodiment of the apparatus of Figure 3.

### DETAILED DESCRIPTION OF THE DRAWINGS

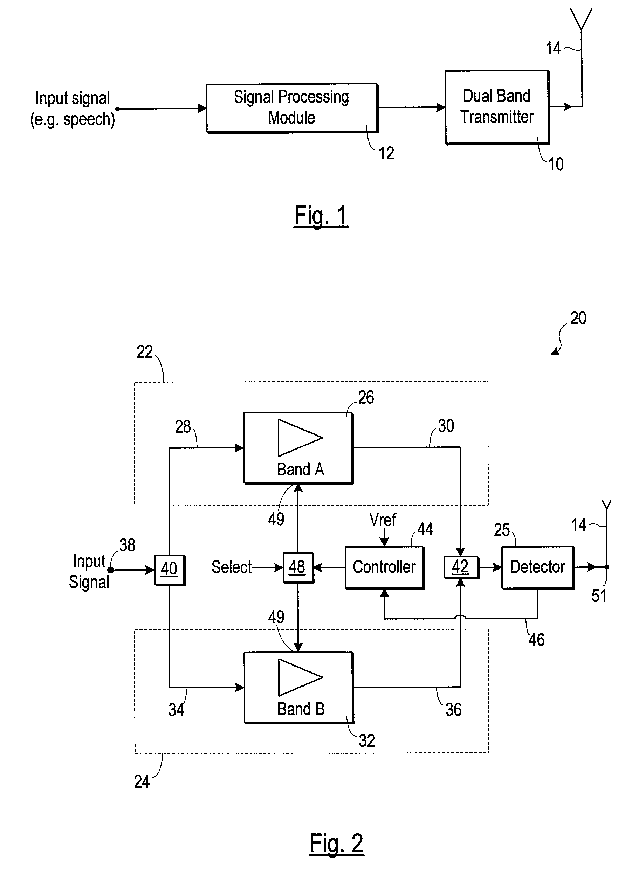

Referring now to Figure 1 of the drawings, there is shown in schematic view the transmit path of a wireless communication apparatus such as a mobile, or cellular, telephone (not shown). In the following description, the communication apparatus is assumed to be a cellular telephone although it will be understood that the invention is not limited to such. The transmit path includes a dual-band transmitter 10 and a signal processing module 12. The signal processing module 12 is arranged to receive an input signal comprising the information or data to be transmitted from the cellular telephone. The input signal typically comprises a speech signal from a microphone (not shown) or a signal generated from a text message. The signal processing module 12 is arranged to perform conventional signal processing operations, such as speech encoding, channel encoding and carrier signal modulation, on the received input signal. To this end, the signal processing module 12 typically includes, or is associated with, a respective signal source (not shown) for providing a respective carrier signal in each of the operational frequency bands. Typically, the signal sources comprise voltage controlled oscillators (VCOs) such as RF (Radio Frequency) sources providing RF carrier signals in, for example, the GSM or DCS bands, although it will be appreciated that the carrier signals may alternatively be in other RF or non-RF frequency bands. The signal processing module 12 then provides the processed signal as an input to the dual-band transmitter 10. In the present example, the signal processing module 12 supplies to the dual-band transmitter 10 an RF signal comprising a carrier signal, in either the GSM or DCS bands, modulated with, for example, voice or text data.

The main purpose of the transmitter 10 is to amplify the processed signal and to supply the amplified signal to an antenna 14 whereupon it is emitted as a radio signal (assuming an RF carrier). The transmitter 10 and the signal processing module 12 are normally provided on the motherboard (not shown) of the cellular phone.

It will be appreciated that Figure 1 and the accompanying description provide a simplistic overview of the transmit path and its components. Further detail, being conventional and not required for understanding the present invention, has been omitted for reasons of clarity.

Figure 2 is a simplified block diagram of one type of conventional dual-band transmitter of which is shown an amplifying apparatus 20 connected to the antenna 14. The amplifying apparatus 20 is a dual-band amplifier comprising first and second amplifying sections 22, 24 and a detector 25. The first amplifying section 22 comprises an amplification device, preferably in the form of a power amplifier 26, an input transmission line 28, and an output transmission line 30. Similarly, the second amplifying section 24 comprises a power amplifier 32, an input transmission line 34 and an output transmission line 36. Each power amplifier 26, 32 is arranged to amplify signals in a respective frequency band *Band A, Band B* which, by way of example, may comprise the GSM and DCS frequency bands.

The input transmission lines 28, 34 are arranged to carry input signals to the respective power amplifier 26, 32 from the input of the amplifying apparatus 20. Since input signals are received via a single input port 38, a switch 40 is provided at the input port 38. The switch 40 is controlled in conventional manner so that input signals in *Band A* are directed to the first power amplifier 26 via transmission line 28, while input signals in *Band B* are directed to the second power amplifier 32 via transmission line 34. Thus, the switch 40 supplies an input signal to only one of the power amplifiers 26, 32 - the "active" power amplifier - at a time, depending on the frequency of the input signal, the other power amplifier 32, 26 being "inactive". The switch 40 has the intended effect of isolating one amplifying section 22, 24 from the other in order to ensure that a signal intended for one power amplifier 26, 32 does not travel along the transmission line 34, 28 leading to the other power amplifier 32, 26.

The output transmission lines 30, 36 are arranged to carry output signals from the respective power amplifier 26, 32 to a diplexer 42. The diplexer 42 is arranged in conventional manner to supply the output of the active power amplifier to an output port 51 of the amplifying apparatus 20 via the detector 25. The output signal is then supplied to the antenna 14 which is arranged to emit signals in *Band A* or *Band B.* The diplexer 42 prevents the output signal from the active power amplifier being fed to the output of the inactive power amplifier and prevents the inactive amplification section from interfering with the impedance matching of the active amplifying section.

The detector 25 forms part of a control loop for ensuring that the power level of the output signal conforms with desired output levels. The detector 25 comprises a conventional current or voltage coupling device, such as an RF coupler comprising two adjacent microstrip lines, that produce a second output signal (on line 46 in Figure 2) that is proportional to the power of the first output signal being supplied to the output port 51.
Conveniently, the second output signal is provided via a diode (not shown) and so takes the form of a voltage signal. The control loop also includes a controller 44 arranged to receive the second output signal from the detector 25 and to compare (using for example a differential amplifier (not shown)) same with a reference signal - in this case a reference voltage V*ref* - which represents the desired output power level. The controller 44 generates a control signal depending on the discrepancy between the reference voltage *Vref* and the voltage received from the detector 25. The control loop further includes a switch 48 arranged to direct, under the control of signal *select,* the control signal to the gain control input 49 of the active power amplifier 26 or 32. The control signal adjusts the gain of the active amplifier 26 or 32 and hence the power of the output signal from the active amplifier. The control process is usually continual and aims to eliminate or minimise the discrepancy between the second output of the detector 25 and the reference voltage *Vref.*

Amplifying apparatus of the general type shown in Figure 2 are commonly known as gain controlled dual-band amplifiers.

A perceived problem with the apparatus 20 of Figure 2 arises from the use of switches 40, 48 to direct the input, output and control signals. Not only does the switching circuitry itself add to the complexity of the apparatus, but the consequent need to provide relatively complex switch control signals also complicates the apparatus 20. Further, the diplexer 42 typically comprises filter circuits and these too add to the complexity of the apparatus.

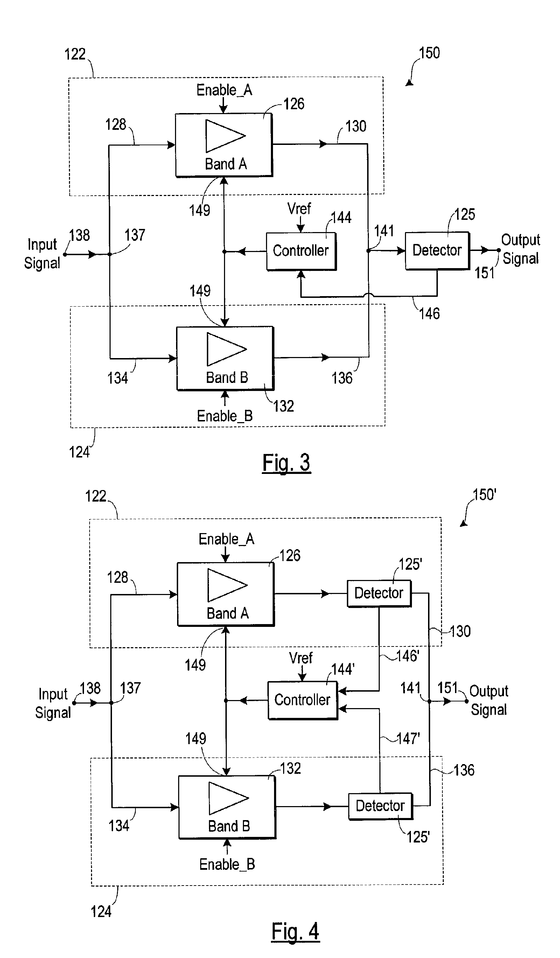

Figure 3 shows a block diagram of a preferred embodiment of an amplifying apparatus 150 according to one aspect of the invention. The amplifying apparatus 150 is of generally similar construction to the amplifying apparatus 20 of Figure 2 and similar reference numerals are used to indicate like parts. The apparatus 150 is also suitable for use in a dual-band transmitter 10 in, for example, the transmit path of a cellular telephone or other mobile telecommunications apparatus. It will be noted that, in the preferred embodiment, the input transmission lines 128, 134 are electrically connected to each other (at a common input 137) and to the input port 138 of the apparatus 150 - there is no switch or switching circuitry for isolating the two amplifying sections 122, 124.

Similarly, the output transmission lines 130, 136 are electrically connected together (at a common output 141) and to the input of the detector 125.

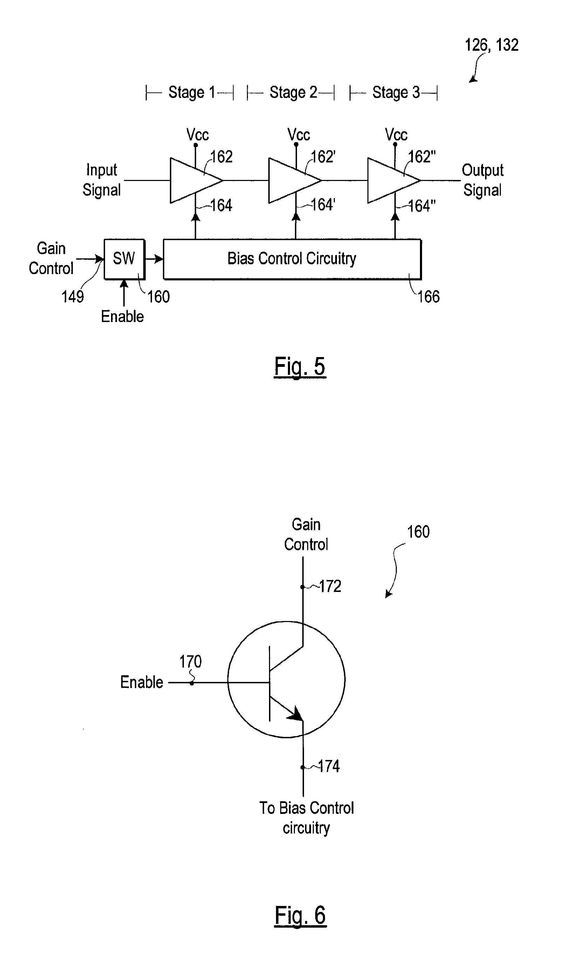

It is also preferred that the output of the controller 144 is connected to each power amplifier 126, 132 without an intervening selector switch so that the gain control signal generated by the controller is supplied to each power amplifier 126, 132 irrespective of whether the power amplifier is active or inactive. In support of this, each power amplifier 126, 132 includes, or is associated with, a respective enabling switch (not shown in Figure 3) arranged to turn the power amplifier 126, 132 on or off depending on the setting of a respective enabling control signal *Enable_A, Enable_B*. The gain control signal is supplied to the respective gain control inputs 149 via the respective enable switches but may or may not be applied to the respective power amplifier 126, 132 depending on the setting of the respective enable switch. This is described in more detail with reference to Figures 5 and 6.

Referring now to Figure 4, there is shown an alternative embodiment of the apparatus of Figure 3. In Figure 4, the amplifying apparatus 150' includes a respective detector 125' for each power amplifier 126, 132. Each detector 125' is arranged to measure, or detect, the level of the output signal from the respective power amplifier 126, 132 and to provide a corresponding output signal to the controller 144' via respective second output lines 146', 147'. After the respective detectors 125', the output transmission lines 130, 136 are electrically connected to each other (at common output 141) and to the output port 151.

One aspect of the invention is now described with reference to Figures 3 and 4. Unlike conventional dual-band amplifiers, the amplifying sections 122, 124 are electrically connected to one another. This is illustrated in Figures 3 and 4 by the connection of the respective input transmission lines 128, 134 at a common input connection point 137, and the connection of the respective output transmission lines 130, 136 at a common output connection point 141. This arrangement is advantageous in that it does not include any switching, or additional matching, circuitry for directing an input signal to one power amplifier or the other, or any switching circuitry for selecting one or other of the power amplifier outputs to supply to the detector 125 (Figure 3 embodiment) or output port 151 (Figure 4 embodiment). Nor is there a requirement for a diplexer at common output point 141. Further, the number of input ports and output ports required by the apparatus 150, 150' is reduced (halved in the present dual-band example). However, there is still a requirement to isolate one amplifying section 122, 124 from the other to prevent input signals being supplied to the inactive power amplifier and to prevent the output signal of the active power amplifier being supplied to the output of the inactive power amplifier - in the conventional circuit of Figure 2, this is achieved by the switch 40 and the diplexer 42. An alternative conventional means of achieving isolation is to provide input signals to the power amplifiers via separate respective input ports although this is considered to be undesirable as it complicates the design.

Another reason to isolate the inactive amplifying section from the active amplifying section concerns impedance matching. Each power amplifier 126, 132 is impedance matched, in conventional manner, with a nominal (or reference) load impedance, typically but not necessarily a 50Ω impedance. Thus, the power amplifier 126, 132 operates with optimum efficiency when connected, at both its input and output, to a 50Ω resistive, or substantially resistive, circuit or load. Assuming that said nominal impedance is 50Ω, in the apparatus 150, 150' of Figures 3 and 4, the input transmission lines 128, 134 are selected to present 50Ω resistive (or substantially resistive) impedance at the respective operation frequency of the power amplifiers 126, 132. Similarly, the output transmission lines 130, 136 are selected to present 50Ω resistive impedance at the respective operation frequency of the power amplifiers 126, 132. As is conventional, other circuitry (not shown) which precedes or follows the apparatus 150, 150' is also matched to the same nominal impedance. Impedance matching optimises power transfer within the overall system and so optimises efficiency.

However, when the amplifying sections 122, 124 are electrically connected as shown in Figures 3 and 4, the inactive amplifying section 122, 124 can have a detrimental effect on the impedance matching at the input and output of the active power amplifier 132, 126.

In accordance with the invention, isolation of amplifying sections 122, 124 is achieved by arranging each amplifying section 122, 124, when inactive, to present a sufficiently high impedance to input signals in the frequency band of the active amplifying section 124, 122 so as to appear substantially as an open-circuit to such input signals. This arrangement prevents the input signals from travelling to the inactive power amplifier 126, 132. Similarly, each amplifying section 122, 124, when inactive, is arranged to present a sufficiently high impedance to output signals from the active amplifying section 124, 122 so as to appear substantially as an open-circuit to such output signals. This arrangement prevents the output signals from the active power amplifier from travelling to the inactive power amplifier 126, 132. The arrangement also minimises the effect that the inactive amplifying section 122, 124 has on the impedance matching in the active amplifying section 124, 122. For example, when the input signal to the apparatus 150, 150' is in frequency *Band A,* the power amplifier 132 is inactive (and disabled) and the amplifying section 124 is arranged to present substantially an open-circuit at connection point 137 to input signals in frequency *Band A.* Also, the amplifying section 124 presents substantially an open circuit at connection point 141 to signals in frequency *Band A.*

In the preferred embodiment, the inactive power amplifier 126, 132 is disabled (turned off) by a respective enabling switch 160 as is described below with reference to Figures 5 and 6. However, the present aspect of the invention need not necessarily be used in conjunction with the single common gain control loop arrangement described with reference to Figures 5 and 6, and the inactive power amplifier may alternatively be disabled by other convenient means. For example, in the case where a selector switch 48 (Fig. 2) is used to direct the gain control signal, the inactive power amplifier may be disabled by setting its gain control input to zero volts.

When the inactive amplifier 126, 132 is disabled, it presents a very high impedance to incoming signals such that it approaches an open-circuit condition. This impedance comprises a very large resistive component, or element, and normally a relatively small reactive component, or element. In many cases, the resistive element is sufficiently large that the overall impedance presented at the input of the disabled power amplifier is sufficiently close to open-circuit that no additional matching is required to effectively isolate the inactive amplifying section from the active amplifying section. Thus, in one embodiment of the invention, the input transmission lines 128, 134 may be omitted and the respective inputs of the power amplifiers 126, 132 are connected directly to the input port 138. More commonly, however, transmission lines 128, 134 are present.

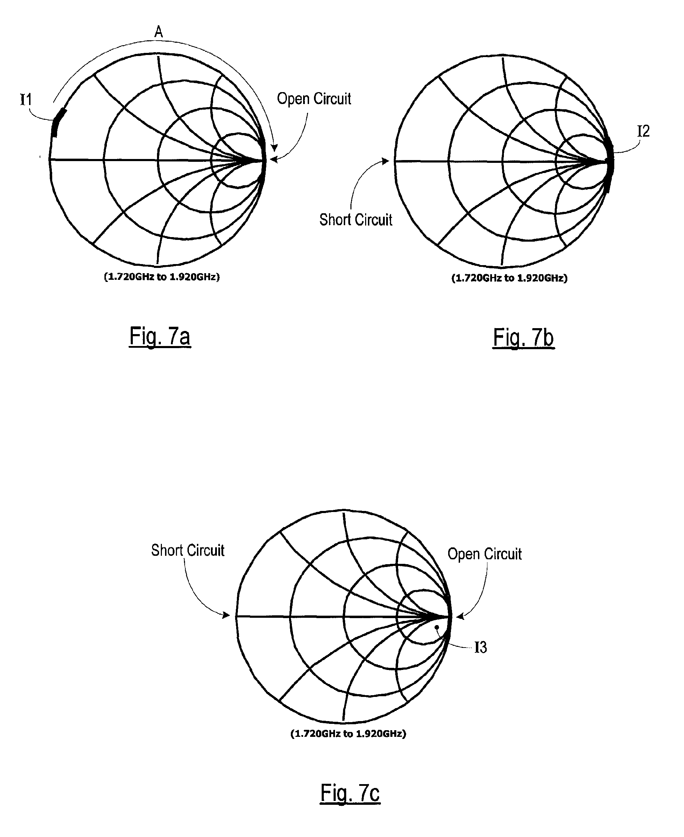

In the following description of a preferred embodiment of the invention, the invention is described in the context of an amplifying apparatus 150 of the type shown in Figure 3. The respective lengths of the input transmission lines 128, 134 are selected so that the combined impedance of the respective transmission line 128, 134 and power amplifier 126, 132 presents a sufficiently large impedance at connection point 137 so as to present, when the respective power amplifier is inactive, substantially an open-circuit to signals in the frequency band of the other (active) power amplifier. The required lengths of the transmission lines 128, 134 depend on the impedance that the respective amplifying section 122, 124 presents to common connection point 137, when inactive, in the absence of the transmission lines 128, 134. A example is described below with reference to Figure 7c.

At the respective outputs of the power amplifiers 126, 132, the impedance presented by the power amplifier 126, 132 itself, when disabled, to signals in the active frequency band tends to comprise both resistive and reactive elements. However, the resulting impedance tends not to be sufficiently high so as to be effectively open-circuit to signals in the active frequency band. In accordance with this aspect of the invention, therefore, the respective lengths of the output transmission lines 130, 136 are selected so that the combined impedance presented by the respective power amplifiers 126, 132, when inactive (disabled), and respective output transmission lines 130, 136 at connection point 141 is substantially open-circuit to signals in the frequency band of the other (active) power amplifier 132, 126. Preferably, the arrangement is such that the combined impedance comprises a very large resistive element and, more preferably, a relatively small, preferably zero, reactive element. Thus, signals emanating from the active power amplifier 126, 132 will not travel to the inactive power amplifier 132, 126 at connection point 141 and the inactive amplifying section 124, 122 does not have a significant effect on the impedance matching at the output of the active power amplifier 126, 132.

It is preferred that the added transmission lines 128, 134, 130, 136 are selected to have a characteristic impedance that matches, or substantially matches, the nominal, or reference, load impedance (50Ω in the present example).

For example, in an ideal case where the power amplifiers 126, 132 are fully open-circuit when inactive, then the respective lengths of the transmission lines 128, 130, 134, 136 may either be of zero length (which may not be practical) or correspond to half of one wavelength in the frequency band of the other amplifying section (this corresponds to 180 electrical degrees or 360° on a conventional Smith Chart) .

In practice, however, the power amplifiers 126, 132, when disabled, do not present a perfect open-circuit. Hence, the length of the transmission lines 128, 130, 134, 136 are selected to compensate for this so that the overall impedance presented by the respective amplifying sections 122, 124, to signals in the other frequency band, when disabled, is effectively equivalent to open-circuit. This is explained by way of example with reference to Figures 7a to 7c which relate to an amplifying apparatus 150 of the type shown in Figure 3.

Figure 7a illustrates, on a representation of a conventional Smith chart, the impedance at the output of the *Band A* power amplifier 126 in the frequency band *Band B* when the amplifier 126 is disabled. In the example of Figures 7a to 7c, *Band B* is assumed to comprise the DCS band at 1.720 GHz to 1.920 GHz. In Figure 7a, the impedance is shown as I1 on the Smith chart. It will be seen that the impedance I1 comprises a small reactive element with a relatively small resistive element. In accordance with this aspect of the invention, the length of the transmission line 130 at the output of the amplifier 126 is selected in order to add phase to the impedance I1 so that the resulting combined impedance of the disabled amplifier 126 and the output transmission line 130 is substantially open-circuit (as is conventional, the open-circuit point is shown on the right-hand side of the Smith chart). On the Smith chart of Figure 7a, this adjustment of the impedance I1 is illustrated by arrow A. Figure 7b shows the resulting combined impedance I2, which is sufficiently high (both resistive and reactive) to serve as an open-circuit.
Thus, when the amplifier 126 is disabled, the amplifying section 122 to which it belongs will have substantially no influence on the operation of the other amplifying section 124 in *Band B.* The transmission line 130 is selected to have a characteristic impedance of 50Ω (assuming a nominal or reference load of 50Ω) and so does not affect the performance of the amplifier 126 in its own operational band, *Band A*, when enabled since the amplifier 126 is matched to this nominal impedance. By adding a transmission line of characteristic impedance that matches the characteristic, or load, impedance of the whole system (50Ω in the present example) only phase (reactive element) is added to the overall impedance presented by the respective amplifying section. However, as can be appreciated from the Smith charts of Figure 7a and 7c, the effect of adding a reactive element to the impedance in this way is to render the impedance substantially open-circuit.

In the present example, the added phase length is approximately 80 degrees on the Smith chart at 1.8 GHz, which corresponds to a transmission line length of approximately 1.3 cm.

Similarly, the required length of transmission line 136 is selected depending on the impedance presented at the output of amplifier 132, when disabled, in the GSM frequency band. This may conveniently be calculated by plotting on a Smith chart (or other suitable means) the impedance presented at the output of amplifier 132 in the GSM frequency band when amplifier 132 is switched off and then determining the length of transmission line 136 required such that the combined impedance at the output of the amplifier 132 and the transmission line 136 is effectively open-circuit.

Figure 7c shows the impedance I3 at the input of the amplifier 126, when disabled, in frequency *Band B.* It will be seen that the impedance I3 comprises a large resistive element and is relatively close to the open-circuit position on the Smith chart even though a reactive element is present. For some applications, this impedance I3 may be considered sufficiently close to open-circuit to have the desired effect and that, therefore, the addition of an input transmission line 128 is not necessary. Preferably, however, a length of transmission line, advantageously of characteristic impedance 50Ω, is added to adjust the phase of the impedance so that the resulting combined impedance is closer to, or at, the open-circuit position. For example, a length of transmission line corresponding to just under one half of one wavelength (360° on a Smith chart, or 180 electrical degrees) at *Band B* may be added to, or used as, the transmission line 128. The length of transmission line 134 may be determined in similar manner.

When selected in accordance with the present invention, the lengths of the transmission lines 128, 130, 146, 136 may be considered to be relatively long, particularly for use in devices such as cellular telephones. It is therefore preferred to implement the amplifying apparatus 150, 150' of the invention on a multi-layer substrate or PCB (printed circuit board) so that the transmission lines may be routed along more than one layer thus reducing the required size of substrate/PCB in terms of length and/or breadth. A multi-layer ceramic substrate is particularly preferred.

By removing the need for switching circuitry to isolate the amplifying sections 122, 124, this aspect of the invention reduces the number of components required to implement the apparatus 150, 150' and reduces its complexity.

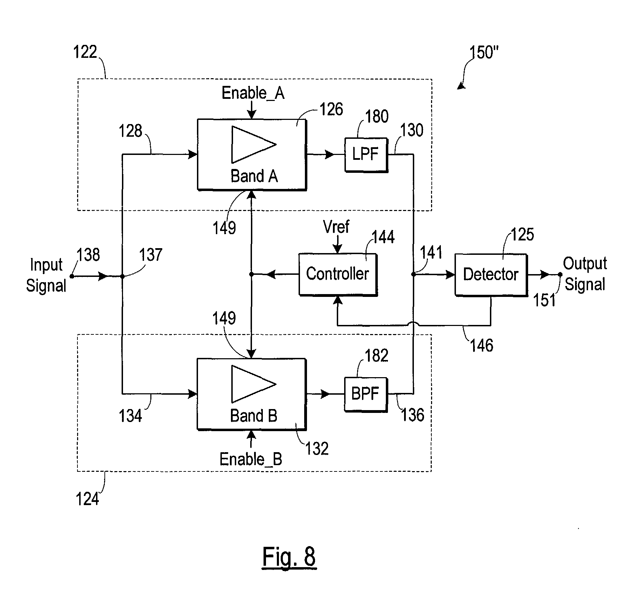

For some commercial applications, it may be necessary to perform signal filtering to ensure that the output signal conforms with any applicable industry standards and/or equipment manufacturer's specifications. For example, in the case where the amplifying apparatus 150 is intended for use in a dual band transmitter 10 of a cellular telephone, and where *Band A* and *Band B* comprise the GSM and DCS frequency bands respectively, signal filtering (including harmonic suppression) is normally required to ensure that the output signal conforms with GSM or DCS industry standards - for example ETSI (European Telecommunications Standards Institute) relating to GSM or DCS transmission - and/or telephone equipment manufacturer's specifications, as applicable. Conventionally, the required filtering is performed by a diplexer (typically located at connection point 141). In the embodiment of Figure 3, if required, a suitable conventional filter network (not shown) may be provided between the connection point 141 and the detector 125. Alternatively, as illustrated in Figure 8, a respective filter circuit 180, 182 may be included in amplifying sections 122, 124 between the respective amplifiers 126, 132 and the common connection point 141. The amplifying apparatus 150'' illustrated in Figure 8 in generally similar to the amplifying apparatus 150 and like numerals are used to indicate like parts. In this example, *Band A* and *Band B* are assumed to comprise the GSM and DCS frequency bands respectively and filters 180, 182 comprise an appropriate conventional Low Pass Filter (LPF) and Band Pass Filter (BPF) respectively. The provision of the filters 180, 182 has an effect on the respective impedance presented by the respective amplifying sections 122, 124 at the common connection point 141. Thus, the respective length of transmission lines 130, 136 is selected such that the respective combined impedance presented by the respective amplifier 126, 132, respective filter 180, 182 and respective transmission line 130, 136 at connection point 141 is substantially, or effectively, open-circuit to signals in the other (active) frequency band when the respective amplifier 126, 132 is disabled.

In Figure 8, the LPF 180 appears as an open-circuit to signals travelling from connection point 141 that are of higher frequency than the cut-off characteristics of the filter 180. In the present example, the cut-off point of the LPF 180 is approximately 1000 MHz (since it is intended to pass signals up to and including GSM band signals), while signals emanating from amplifying section 124, when active, are in the DCS band (approximately 1800 MHz). Thus, when amplifying section 122 is inactive and amplifying section 124 is active, LPF 180 appears effectively as open-circuit to DCS signals emanating from amplifying section 124. Therefore, the required length of the transmission line 130 may be zero (or substantially zero) or may correspond to one half of one wavelength at DCS frequency (360° on a Smith Chart, or 180 electrical degrees), or a multiple thereof. Hence, the combined impedance presented by the amplifier 126, the filter 180 and the transmission line 130 (if any) at connection point 141 is effectively open-circuit. In practice, it may be difficult to omit the transmission line 130 completely (zero length) and so a transmission line 130 length of approximately half a wavelength (or a multiple thereof) at DCS is preferred.

The required length of transmission line 136 may be determined in similar manner. In Figure 8, the BPF 182 (which is arranged to pass signals in the DCS band) is effectively short-circuit to signals in the GSM frequency band. The length of transmission line 136 is selected so that the combined impedance of the BPF 182 and the transmission line 136 at connection point 141 is effectively open-circuit. The move from short-circuit to open-circuit corresponds to 180° on a Smith Chart, or one quarter of one wavelength (90 electrical degrees) at GSM. Thus, the required length of transmission line 136 corresponds to approximately one quarter of one wavelength at GSM.

Referring now to Figure 4, the respective lengths of the transmission lines 130, 136 of amplifying apparatus 150' are selected so that the respective combined impedance presented by the respective amplifier 126, 132, respective detector 125', and respective transmission line 130, 136 at connection point 141 is substantially, or effectively, open-circuit to signals in the other (active) frequency band when the respective amplifier 126, 132 is disabled. Conveniently, this may be calculated by plotting the impedance presented at connection point 141 by the respective disabled amplifier 126, 132 and the respective detector 125' on a Smith chart (or equivalent device) and then determining what length of transmission line 130, 136 is required to move the Smith chart plot to the open-circuit state (normally the right-hand side of the Smith chart). A respective filter may also be provided in each amplifying section, if required.

It will be noted that the line section between the amplifier 126, 132 and the detector 125'/filter 180, 182 (in the Figure 4 and Figure 8 embodiments respectively) typically comprises an output match for the respective amplifier 126, 132 and a transmission line of characteristic impedance 50Ω (in this example). In general, where one or more devices, such as a detector and/or a filter, are provided between the amplifier and the common connection point, it is the length of the transmission line between the common connection point and the nearest of the, or each, device that is selected or determined in accordance with the invention. The required length of transmission line may be determined by measuring the impedance presented to the common connection point at the nearest of the, or each, device to signals in the other frequency band travelling from the common connection point when the amplifier is disabled (this impedance may comprise the cumulative impedance presented by one or more of the disabled amplifier and the, or each device). The required length of transmission line is that required to adjust the measured impedance to a substantially open-circuit state.

Referring now to Figure 5, there is shown a block diagram of the preferred embodiment of the power amplifier 126, 132 including an enabling switch 160 in accordance with a preferred aspect of the invention. The power amplifier 126, 132 comprises a cascade or chain of amplifying stages (preferably a chain of three stages, annotated as *stage 1*, *stage 2* and *stage 3* in Figure 5) each stage comprising a respective amplifier 162, 162', 162'' in the form of, for example, a heterojunction bipolar junction transistor (HBT) in, for example, Silicon Germanium (SiGe) or Gallium Arsenide (GaAs) technology. Each amplifier 162, 162', 162'' is connected to a supply voltage *Vcc* in conventional manner. The amplifiers 162, 162', 162'' also have a respective gain, or bias, control input 164, 164', 164'' which, in the case where the amplifiers 162, 162', 162'' comprise bipolar transistors, may be provided by the base input of the transistor. It will be understood that the amplifiers 162, 162', 162'' are not necessarily identical and normally have different amplifying characteristics, as is conventional in a multi-stage amplifying chain. The power amplifier 126, 132 further includes conventional bias control circuitry 166 for controlling the respective gain of the amplifiers 162, 162', 162'' by supplying a bias control signal which, in the present example, involves adjusting the respective base, or bias, voltages of the amplifiers 162, 162', 162'' via the base inputs 164, 164', 164''.

The amplifier chain and the bias control circuitry 166 are of generally conventional design. Additional conventional circuitry such as input, output and inter-stage matching networks are not shown in Figure 5 for reasons of clarity. Conventionally, a gain control signal from the controller 144, 144' (see Fig. 3 and Fig. 4) is supplied directly to the bias control circuitry 166 in accordance with which the bias control circuitry 166 adjusts the individual gains of the amplifiers 162, 162', 162'' thereby adjusting the gain of the overall power amplifier. In the arrangement of Figure 5, the gain control signal is supplied to the bias control circuitry via the enabling switch 160. The enabling switch 160 is operated by an *enable* signal (*Enable_A, Enable_B* in Figures 3 and 4) which may be set to turn the enabling switch 160 on or off. For example, the enabling switch 160 is turned off when an enable signal of 0 Volts is applied, and on when an enable signal of approximately 1 Volt is applied. When the enabling switch 160 is turned off, the gain control signal is isolated from the bias control circuitry 166 (in effect a zero bias control signal) with the result that the bias control circuitry 166 acts to turn each of the amplifiers 162, 162', 162'' off by, for example, applying a base voltage of 0 Volts to each amplifier 162, 162', 162''. This has the effect of disabling the power amplifier 126, 132.

When the enabling switch 160 is turned on, the gain control signal is passed through the enabling switch 160 to the bias control circuitry 166. The power amplifier 126, 132 is thus enabled and operates in normal manner.

Figure 6 shows a preferred embodiment of the enabling switch 160 in the form of a conventional bipolar transistor. The enable signal is supplied to the base input 170 of the transistor, the gain control signal is supplied to the collector input 172 (which corresponds with the gain control input 149 in Fig. 5) and the emitter 174 is connected to the bias control circuitry 166. When the enable signal is set at 0 Volts, the base voltage of the transistor is zero and the transistor is turned off. Hence, no current is able to flow between the collector 172 and the emitter 174 and so the gain control signal is isolated from the bias control circuitry 166. However, when the enable signal is set so that the base voltage exceeds the base-emitter diode voltage (≈ 0.7V on SiGe), the transistor is turned on and current flow is enabled from collector 172 to emitter 174. To turn the transistor on, a base voltage value higher than the base-emitter diode voltage is preferably chosen to enable strong current flow.

The enabling signal may be provided in any suitable manner. For example, the apparatus 150, 150' may include a user settable switch (not shown), the setting of which sends a control signal to one or other of the enable inputs. Alternatively, the enabling signal may be derived from the respective signals that enable the RF sources.

Power amplifiers are commonly provided as units, for example in a single Integrated Circuit (IC) package, such as a MMIC (monolithic microwave integrated circuit). Conveniently, the enabling switch 160 is incorporated into the power amplifier unit, e.g. as part of the single IC package. Alternatively, the enabling switch 160 may be provided externally of the power amplifier unit.

Referring again to Figures 3, 4, and 8, it will therefore be seen that the gain control loop for each amplifier 126, 132 are electrically connected to each other and the controller 144, 144' supplies the gain control signal to both of the power amplifiers 126, 132 simultaneously. In effect, the apparatus 150, 150', 150'' comprises a single gain control loop which supplies the same gain control signal to each amplifying section 122, 124 simultaneously. In use, the inactive power amplifier is disabled by its respective enabling switch 160 and so only the active power amplifier is able to respond normally to the applied gain control signal. This arrangement removes the need for switching circuitry between the controller 144, 144' and the power amplifiers 126, 132 to swap the gain control loop between amplifying sections 122, 124. Not only does this reduce the complexity of the gain control circuitry but it also removes the need to provide switch control signals to operate such switching circuitry. This results in a reduction in the size of the amplifying apparatus 150, 150', 150'' and simplification of its control.

It will be apparent to a skilled person that the arrangement described above may readily be extended to multi-band amplifying apparatus (not shown) having three or more amplifying sections, wherein each amplifying section comprises a respective power amplifier with a respective enabling switch and the gain controller supplies the gain control signal to each power amplifier simultaneously via the respective enabling switches.

The apparatus 150, 150', 150'' of the invention may be implemented in a number of conventional ways, for example as one or more integrated circuits and/or other conventional electronic components mounted on a substrate, preferably a multi-layer substrate. Alternatively, the apparatus, or a part thereof, may be described, or defined, using a hardware description language (HDL) such as VHDL, Verilog HDL or a targeted netlist format (e.g. xnf, EDIF or the like) recorded in an electronic file, or computer useable file.

Thus, the invention further provides a computer program, or computer program product, comprising program instructions, or computer usable instructions, arranged to generate, in whole or in part, an apparatus according to the invention. The invention may therefore be implemented as a set of suitable such computer programs. Typically, the computer program comprises computer usable statements or instructions written in a hardware description, or definition, language (HDL) such as VHDL, Verilog HDL or a targeted netlist format (e.g. xnf, EDIF or the like) and recorded in an electronic or computer usable file which, when synthesised on appropriate hardware synthesis tools, generates semiconductor chip data, such as mask definitions or other chip design information, for generating a semiconductor chip. The invention also provides said computer program stored on a computer useable medium. The invention further provides semiconductor chip data, stored on a computer usable medium, arranged to generate, in whole or in part, an apparatus according to the invention.

The invention is not limited to the embodiments described herein which may be modified or varied without departing from the scope of the invention.

## Claims

1. An amplifying apparatus for amplifying a signal having a frequency in one of a plurality of frequency bands, the apparatus comprising: a first amplifying section comprising an amplifier arranged to operate in a first of said frequency bands; a second amplifying section comprising an amplifier arranged to operate in a second of said frequency bands; and at least one common connection point to which each of the first and second amplifying sections is electrically connected, wherein, when the respective amplifier of said first or second amplifying section is disabled, the respective first or second amplifying section is arranged to present an impedance at said at least one common connection point which is substantially open-circuit to signals in said second or first frequency bands respectively.

2. An apparatus as claimed in Claim 1, wherein said at least one common connection point comprises a common output, the respective outputs of the first and second amplifying sections being electrically connected to each other at the common output.

3. An apparatus as claimed in Claim 2, wherein each amplifying section comprises a respective output transmission line between the common output and the respective amplifier, the length of the output transmission line being arranged to adjust the impedance presented at said common output by the respective amplifying section when disabled.

4. An apparatus as claimed in Claim 3, wherein each amplifying section comprises a respective filter circuit and the respective output transmission line connects the respective filter circuit to the common output.

5. An apparatus as claimed in Claim 3, wherein each amplifying section comprises a respective detector circuit and the respective output transmission line connects the respective detector circuit to the common output.

6. An apparatus as claimed in any preceding claim, wherein said at least one common connection point includes a common input by which a signal may be supplied to one or other of said amplifying sections, wherein said first and second amplifying sections are electrically connected to each other at said common input and wherein, when the respective amplifier of said first or second amplifying section is disabled, the respective first or second amplifying section is arranged to present an impedance at said common input which is substantially open-circuit to signals in said second or first frequency bands respectively.

7. An apparatus as claimed in Claim 6, wherein each amplifying section comprises a respective input transmission line between the common input and the respective amplifier, the length of the input transmission line being arranged to adjust the impedance presented at said common input by the respective amplifying section when disabled.

8. An apparatus according to any of Claims 3 to 7, in which the output transmission lines and/or the input transmission lines have a characteristic impedance which substantially matches the load impedance of the respective amplifiers.

9. An apparatus as claimed in any of claims 3 to 7, wherein the respective output transmission line and/or the respective input transmission line is arranged to add to the reactive component of the respective amplifying section when disabled.

10. An apparatus as claimed in any preceding claim, wherein the respective amplifier of the first and second amplifying section is associated with a respective enable switch operable by a respective enable signal for enabling the respective amplifier when the signal is in the first and second frequency bands respectively and to disable the respective amplifier when the signal is in said second and first bands respectively.

11. An apparatus as claimed in Claim 10, wherein said enable signals are derived from the respective enabling signal for the signal source for the first and second frequency bands respectively.

12. An apparatus as claimed in Claim 10 or 11, in which the amplifier of each amplifying stage comprises a variable gain amplifier, the respective enable switch being arranged to enable and disable the power amplifier by enabling and disabling the gain control input respectively.

13. An apparatus as claimed in Claim 12, further comprising a gain controller arranged to generate a gain control signal for adjusting the gain of the amplifiers, wherein the gain control signal is supplied to each of the gain control inputs of the amplifiers via the respective enable switches.

14. A dual-band transmitter comprising an apparatus as claimed in any of claims 1 to 13.

15. A mobile telecommunications apparatus comprising a dual-band transmitter including an apparatus as claimed in any of claims 1 to 13.

16. A computer program product comprising computer useable instructions for generating an apparatus as claimed in any of claims 1 to 13.

17. In an amplifying apparatus for amplifying a signal having a frequency in one of a plurality of frequency bands, the apparatus comprising: a first amplifying section comprising an amplifier arranged to operate in a first of said frequency bands; a second amplifying section comprising an amplifier arranged to operate in a second of said frequency bands; and a common output to which each of the first and second amplifying sections is connected, the first and second amplifying sections being electrically connected to each other at said common output, a method of isolating said first and second amplifying sections, the method comprising: arranging the respective first or second amplifying section to present, when the respective amplifier of said first or second amplifying section is disabled, an impedance at said common output which is substantially open-circuit to signals in said second or first frequency bands respectively.

18. An amplifying apparatus for amplifying a signal having a frequency in one of a plurality of frequency bands, the apparatus comprising: a first amplifying section comprising an amplifier arranged to operate in a first of said frequency bands; a second amplifying section comprising an amplifier arranged to operate in a second of said frequency bands; wherein the respective amplifier of the first and second amplifying section is associated with a respective enable switch operable by a respective enable signal to enable the respective amplifier when the signal is in the first and second frequency bands respectively and to disable the respective amplifier when the signal is in said second and first bands respectively, the amplifier of each amplifying stage comprising a variable gain amplifier and the apparatus further comprising a gain controller arranged to generate a gain control signal for adjusting the gain of the amplifiers, wherein the gain control signal is supplied to each of the gain control inputs of the power amplifiers via the respective enable switches.
